(19) Europäisches Patentamt / European Patent Office / Office européen des brevets

(11) **EP 2 895 871 B1**

(12) **FASCICULE DE BREVET EUROPEEN**

(45) Date de publication et mention
de la délivrance du brevet:
**14.09.2016 Bulletin 2016/37**

(21) Numéro de dépôt: **13762508.3**

(22) Date de dépôt: **16.09.2013**

(51) Int Cl.:
*G01R 29/10* (2006.01)    *H01Q 9/28* (2006.01)

(86) Numéro de dépôt international:
**PCT/EP2013/069176**

(87) Numéro de publication internationale:
**WO 2014/041177 (20.03.2014 Gazette 2014/12)**

(54) **DISPOSITIF DE MESURE DE GAIN DE CAPTEUR DE CHAMP ELECTROMAGNETIQUE**

VORRICHTUNG ZUR MESSUNG DER VERSTÄRKUNG EINES ELEKTROMAGNETFELDSENSORS

DEVICE FOR MEASURING THE GAIN OF AN ELECTROMAGNETIC FIELD SENSOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.09.2012 FR 1258697**

(43) Date de publication de la demande:
**22.07.2015 Bulletin 2015/30**

(73) Titulaire: **Commissariat à l'Énergie Atomique et aux Énergies Alternatives
75015 Paris (FR)**

(72) Inventeur: **POUZALGUES, Romain
F-46500 Miers (FR)**

(74) Mandataire: **Brevalex
95, rue d'Amsterdam
75378 Paris Cedex 8 (FR)**

(56) Documents cités:
**EP-A1- 1 063 528        EP-A1- 1 722 243
WO-A1-2009/143216      JP-A- 2008 047 994**

- **FRANDSEN A ET AL: "Control of scattering from probes for near-field antenna measurements by use of skirt", ELECTRONICS LETTERS, IEE STEVENAGE, GB, vol. 40, no. 5, 4 mars 2004 (2004-03-04), pages 284-285, XP006021560, ISSN: 0013-5194, DOI: 10.1049/EL:20040179**
- **RONALD R DELYSER ET AL: "Figure of Merit for Low Frequency Anechoic Chambers Based on Absorber Reflection Coefficients", IEEE TRANSACTIONS ON ELECTROMAGNETIC COMPATIBILITY, IEEE SERVICE CENTER, NEW YORK, NY, US, vol. 38, no. 4, 1 novembre 1996 (1996-11-01), XP011019454, ISSN: 0018-9375**

EP 2 895 871 B1

## Description

Domaine technique et art antérieur

L'invention concerne un dispositif de mesure de gain de capteur de champ électromagnétique.

Par capteur de champ électromagnétique, il faut entendre, par exemple, une antenne apte à recevoir ou émettre des ondes électromagnétiques.

L'invention s'applique à la mesure des gains de capteurs de champ électromagnétique d'espace libre ou de paroi, dans des bandes de fréquences larges, par exemple la bande 100MHz - 40GHz.

A ce jour, il existe différents types de dispositifs aptes à mesurer le gain des capteurs de champ électromagnétique.

Parmi les dispositifs connus, certains ne mesurent le gain des capteurs d'espace libre ou de paroi que sur des bandes de fréquences relativement étroites (typiquement autour de 1GHz). Ces dispositifs sont constitués par des cellules telles que les cellules de Crawford ou les cellules GTEM (GTEM pour « Gigahertz Transverse ElectroMagnetic »).

D'autres systèmes connus réalisent des caractérisations de systèmes rayonnants en espace libre en trois dimensions. Ces systèmes effectuent des mesures dans des bandes de fréquences plus larges que celles des cellules mentionnées ci-dessus. Toutefois, afin de couvrir de larges bandes de fréquences, ces systèmes nécessitent l'utilisation de plusieurs antennes d'émission différentes, chaque antenne d'émission rayonnant une onde électromagnétique dans une fraction de la bande de fréquences utile. Il en résulte un dispositif de mesures complexe et couteux.

Le dispositif de l'invention ne présente pas ces inconvénients.

Exposé de l'invention

En effet, l'invention concerne un dispositif de mesure de gain de capteur de champ électromagnétique selon la revendication 1.

Selon une caractéristique supplémentaire de l'invention, une ouverture est pratiquée dans l'élément conducteur plan et des moyens mécaniques aptes à fixer une extrémité d'un câble coaxial sur l'élément conducteur plan sont fixés sur la deuxième face de l'élément conducteur plan, au niveau de l'ouverture pratiquée dans l'élément conducteur plan, les moyens mécaniques présentant une ouverture alignée avec l'ouverture pratiquée dans l'élément conducteur plan et comprenant un connecteur électriquement relié à l'extrémité du câble coaxial, le connecteur ayant un conducteur central fixé à une première extrémité d'une pièce de connexion dont la deuxième extrémité est fixée à une extrémité de la pièce conductrice en forme de cône.

Selon une autre caractéristique supplémentaire de l'invention, l'élément conducteur plan est constitué d'une plaque munie d'une ouverture et d'un clinquant flexible de métal fixé à la plaque qui emplit l'ouverture pratiquée dans la plaque, le clinquant flexible étant muni d'une ouverture qui constitue l'ouverture de l'élément conducteur plan, les moyens mécaniques étant fixés sur le clinquant flexible.

Selon encore une autre caractéristique supplémentaire de l'invention, le clinquant flexible de métal est fixé à la plaque par un ruban adhésif métallique.

Selon encore une autre caractéristique supplémentaire de l'invention, l'élément conducteur plan est muni d'un plateau tournant sur lequel est placé le capteur.

Selon encore une autre caractéristique supplémentaire de l'invention, la pièce conductrice en forme de cône est constituée de deux parties séparables vissées l'une à l'autre, une première partie comprenant la pointe du cône et la deuxième partie constituant le corps du cône.

Selon encore une autre caractéristique supplémentaire de l'invention, la pièce conductrice en forme de cône est maintenue au dessus de l'élément plan par un système de suspension par câbles.

Brève description des figures

D'autres caractéristiques et avantages de l'invention apparaîtront à la lecture d'un mode de réalisation préférentiel décrit en référence aux figures jointes, parmi lesquelles :

- La figure 1 représente un shéma de principe de dispositif de mesure de gain de capteur de champ électromagnétique de l'invention ;
- La figure 2 représente le mode de réalisation préférentiel d'une structure mécanique qui participe au dispositif de mesure de gain de capteur de champ électromagnétique de l'invention ;
- La figure 3 représente une pièce mécanique particulière qui participe à la structure mécanique de la figure 2 ;
- Les figures 4A-4E représentent différentes étapes de fabrication de la structure représentée en figure 2 ;
- La figure 5 représente le schéma de principe d'une antenne monocônique ;
- La figure 6 représente un exemple de mesure du coefficient de réflexion d'une antenne monoconique conforme à l'invention

Sur toutes les figures, les mêmes références désignent les mêmes éléments.

Exposé détaillé d'un mode de réalisation préférentiel de l'invention

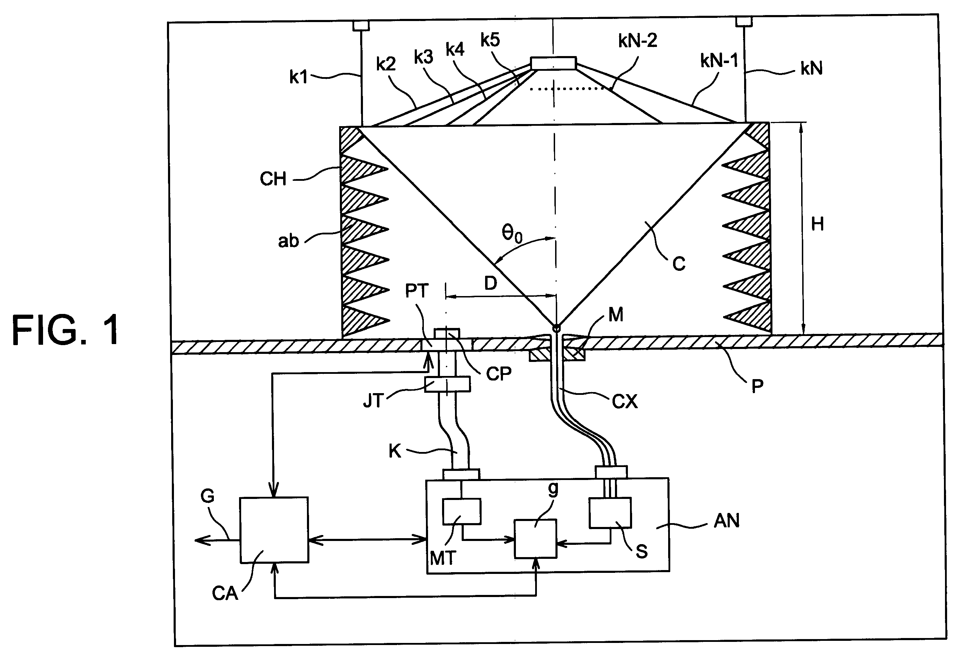

La figure 1 représente un schéma de principe du dispositif de mesure de gain de capteur de champ électromagnétique de l'invention.

Le dispositif de mesure comprend les éléments essentiels suivants:

- une antenne monocônique constituée d'une pièce conductrice en forme de cône C et d'un élément plan électriquement conducteur P,
- une source d'ondes électromagnétiques S,
- un câble coaxial CX qui relie la source d'ondes électromagnétiques S à l'antenne monocônique,
- un système de mesure de tension MT apte à mesurer la tension délivrée par le capteur,
- un système de calcul de gain g apte à mesurer le gain en tension du capteur (rapport entre la tension délivrée par le système de mesure de tension et la tension incidente appliquée à l'entrée de l'antenne monocônique), et
- un calculateur CA apte à calculer le gain G du capteur à partir du gain en tension calculé par le système de calcul de gain g.

Le capteur CP dont le gain est à déterminer est placé dans l'espace situé entre l'élément plan électriquement conducteur P et la surface de la pièce conductrice en forme de cône C, par exemple sur l'élément plan P lui-même. Dans un mode de réalisation particulier de l'invention, la source d'ondes électromagnétiques S, le système de mesure de tension MT et le système de calcul de gain g sont des circuits électroniques d'un analyseur de réseau AN. Dans une variante du mode de réalisation particulier de l'invention, un amplificateur amplifie le signal délivré par l'analyseur de réseau.

Un système de suspension par câbles k1, k2, k3, k4, k5, ..., kN-2, kN-1, kN maintient le cône C au dessus de l'élément conducteur plan P pour former l'antenne monocônique.

L'onde électromagnétique rayonnée par l'antenne monocônique est confinée dans une chambre anéchoïde CH faite d'une première face de l'élément plan P, de la surface extérieure de la pièce conductrice C et d'une paroi recouverte d'absorbants Ab qui entoure la pièce C. La hauteur H de la paroi recouverte d'absorbants est par exemple égale à 2,5m et l'angle d'ouverture $\theta_0$ de la pièce conique par exemple égal à 47°.

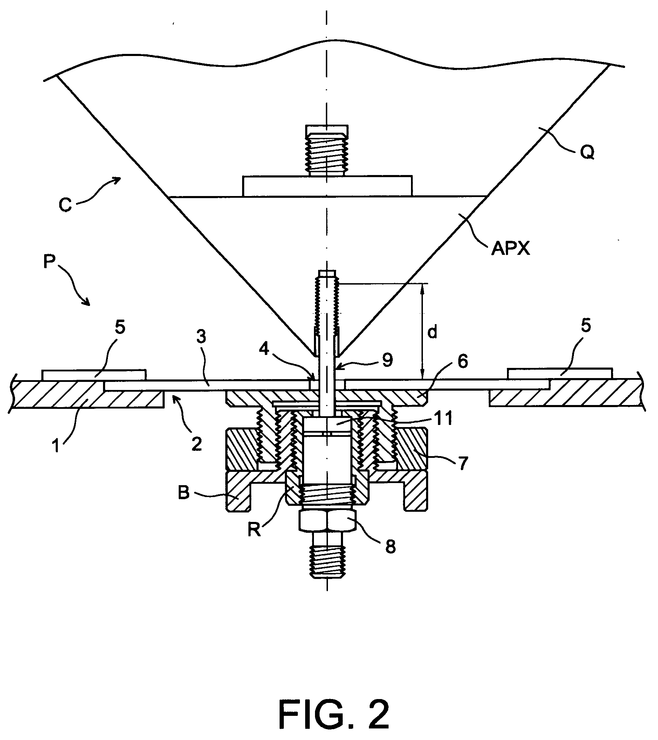

L'élément plan électriquement conducteur P est muni d'un trou débouchant dans lequel se loge une première extrémité du câble coaxial CX dont la deuxième extrémité est reliée à la source d'ondes électromagnétiques. La première extrémité du câble coaxial est fixée par des moyens mécaniques M sur la deuxième face de l'élément plan, située à l'opposé de la première face. Le conducteur central du câble coaxial CX s'élève d'une faible hauteur au-dessus de la première face de l'élément plan P et est électriquement relié à l'extrémité de la pièce conductrice en forme de cône C. L'élément conducteur plan P est la masse de l'antenne monocônique. Ainsi, le conducteur de masse du câble coaxial est-il électriquement relié à l'élément conducteur plan P. Selon le mode de réalisation de représenté en figure 1, la tresse conductrice de masse du câble coaxial est directement reliée à l'élément plan P, préférentiellement par soudure, au niveau de la première extrémité du câble coaxial. Selon d'autres modes de réalisation de l'invention (cf. figure 2), la tresse conductrice de masse du câble coaxial est électriquement reliée à la masse d'un connecteur qui appartient aux moyens mécaniques M.

Le capteur CP dont la courbe de gain est à déterminer est placé, par exemple, sur la première face de l'élément plan P à une distance D de l'axe du cône égale, par exemple, à 1,5 m. Le capteur CP a sa sortie reliée au système de mesure, via un câble coaxial K. Selon un perfectionnement de l'invention, le capteur CP est placé sur un plateau tournant motorisé PT. Le câble coaxial K est alors équipé d'un joint tournant JT et le plateau tournant PT est commandé par un signal de commande délivré par un calculateur PC. Il est alors possible de modifier l'incidence de l'onde électromagnétique sur le capteur CP.

La figure 2 représente le mode de réalisation préférentiel d'une structure mécanique qui participe au dispositif de mesure de gain de capteur de champ électromagnétique de l'invention. Plus particulièrement, la figure 2 représente la liaison mécanique et électrique qui existe entre le câble coaxial et la pointe de la pièce conique C.

Le cône C est constitué d'un corps de cône Q fixé par vissage à une pointe de cône APX. L'élément conducteur plan P est constitué d'une plaque 1 munie d'une ouverture 2 dans laquelle est fixé un clinquant flexible de métal 3. Le clinquant flexible 3, par exemple un cliquant de cuivre, est percé en son centre d'une ouverture 4 placée en regard de l'extrémité de la pointe du cône. Une première face de la plaque 1 et une première face du clinquant flexible 3 définissent la première face de l'élément conducteur plan P. L'épaisseur de la plaque 1 est par exemple égale à 5mm et l'épaisseur du clinquant 3 par exemple égale à 0,5mm. Un ruban adhésif métallique 5 fixe la première face de la plaque 1 à la première face du clinquant flexible 3.

Les moyens mécaniques M qui assurent la fixation du câble à l'élément conducteur plan P comprennent une pièce métallique 6, une bague de réglage B, une pièce R de reprise de connecteur, un contre-écrou 7, un connecteur 8 et une entretoise 11. La pièce métallique 6 comprend une partie plane qui est fixée, par exemple par soudure, sur la deuxième face du clinquant de métal 3 située à l'opposé de la première face. La partie plane de la pièce métallique 6 est munie d'une ouverture qui est alignée avec l'ouverture 4. La pièce métallique 6 comprend également, à partir de la partie plane, une partie cylindrique creuse qui entoure l'ouverture pratiquée dans la partie plane et dans laquelle sont logés successivement, en partant de la partie cylindrique creuse, la bague de réglage B, la pièce de repise R, le connecteur 8 et l'entretoise 11.

Par ailleurs, le conducteur central du connecteur 8 est électriquement relié à l'extrémité du cône C par une pièce de connexion électrique 9. La pièce de connexion électrique 9 s'élève d'une distance d au dessus de la première face du clinquant de métal.

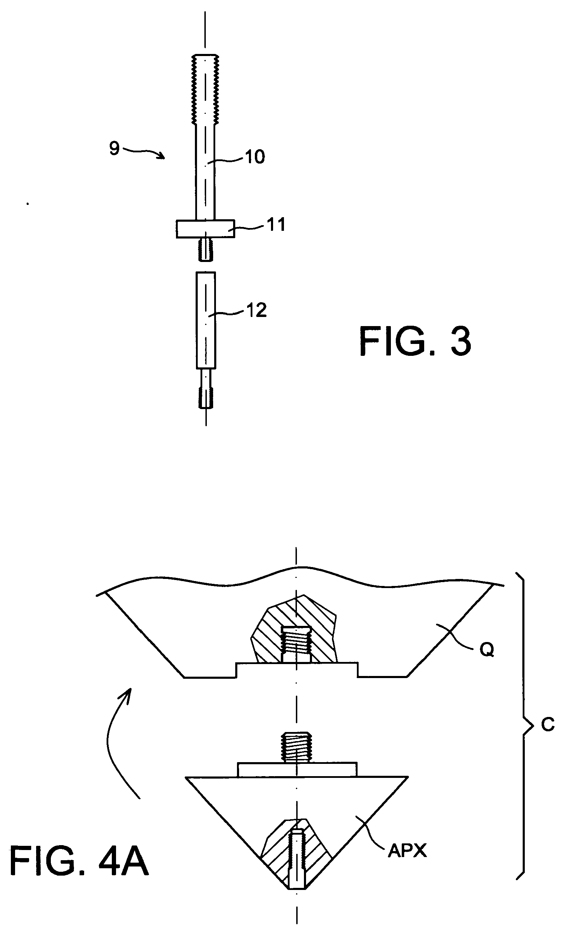

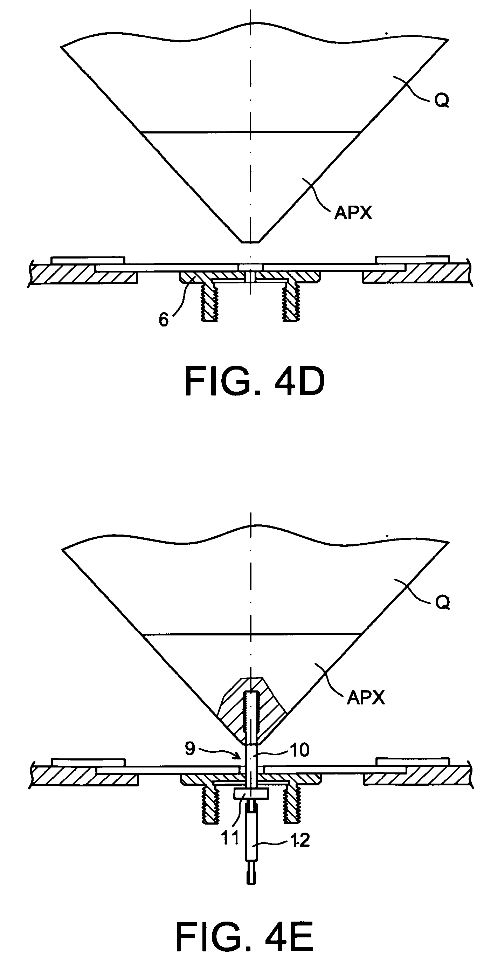

La figure 3 représente une vue en éclaté de la pièce de connexion électrique 9. La pièce de connexion électrique 9 comprend deux éléments en forme de tige 10, 12 qui sont enfichés l'un dans l'autre pour former un élément unique dont les deux extrémités sont filetées. La fixation de la pièce de connexion électrique 9 à l'extrémité du cône C est faite par vissage de l'extrémité filetée de la pièce 10 à l'intérieur de l'extrémité de la pointe APX du cône. La fixation de la pièce de connexion 9 au conducteur central du connecteur 8 est faite par vissage de l'extrémité filetée de la pièce 12 au conducteur central du connecteur 8. Pour des raisons de commodité de montage (cf. la figure 4E), l'entretoise 11 est montée sur l'élément en forme de tige 10, à proximité de la liaison entre les pièces 10 et 12.

Les figures 4A-4E représentent différentes étapes de fabrication de la structure représentée en figure 2. Ces différentes étapes sont les suivantes :

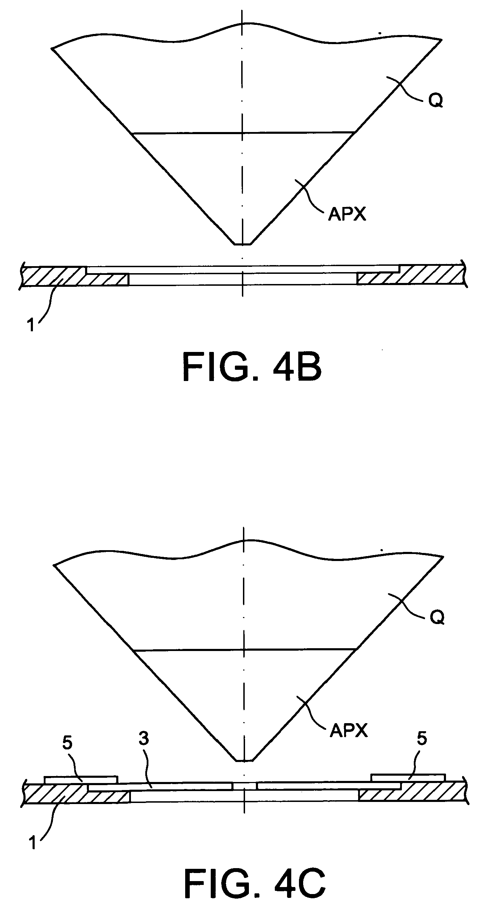

- Fixation par vissage de la pointe APX et du corps Q du cône (figure 4A);
- Positionnement du cône au-dessus de l'ouverture pratiquée dans l'élément conducteur plan P à l'aide du système de suspension par câbles (figure 4B) ;
- Fixation du clinquant flexible 3 sur la première face de l'élément conducteur plan P à l'aide de ruban métallique adhésif 5 (figure 4C) ;
- Fixation par soudage de la pièce métallique 6 sur le clinquant flexible 3 (figure 4D) ;
- Fixation par vissage de la pièce de connexion électrique 9 à l'extrémité de la pointe APX du cône (figure 4E).

Une fois la pièce de connexion électrique 9 fixée au cône C, le contre-écrou 7 est vissé sur la partie cylindrique extérieure de la pièce 6 et la bague de réglage B est vissée sur la partie cylindrique intérieure de la pièce 6. On visse ensuite la reprise R de connecteur sur la bague de réglage B. Puis, la partie extérieure du connecteur 8 est vissée sur la reprise de connecteur R alors-même que le conducteur central du connecteur 8 est vissé à l'extrémité filetée de la pièce 12 en forme de tige. Le positionnement final du connecteur 8 s'effectue à l'aide de la bague de réglage B. Le contre-écrou 7 permet de verrouiller la position de la bague B et, en conséquence, du connecteur, dès lors qu'une position optimale du connecteur est trouvée.

De façon avantageuse, la présence du clinquant de métal flexible permet d'amortir les mouvements relatifs de la pièce conique C et de l'élément plan P, tant lors de l'opération de fixation du cône au câble coaxial qu'ultérieurement, lorsque le dispositif de mesure de gain fonctionne.

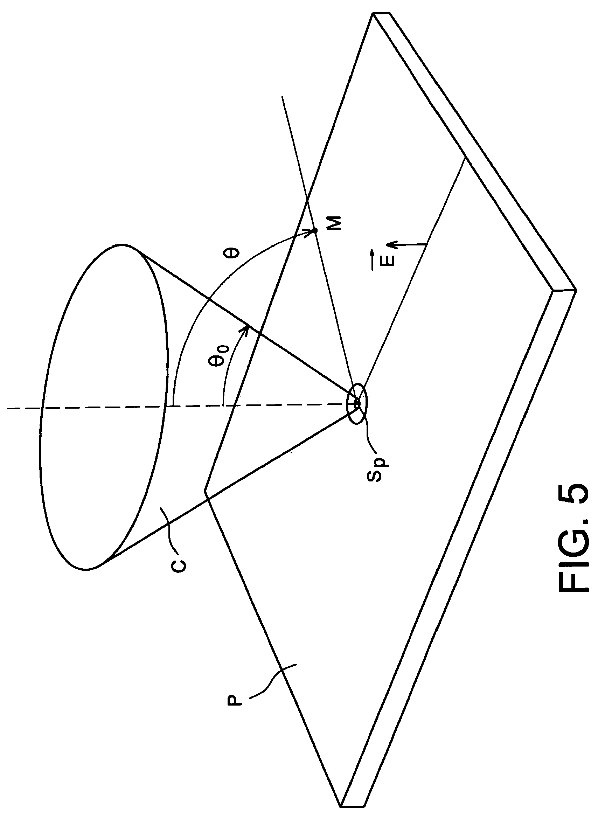

La figure 5 représente le schéma de principe d'une antenne monoconique.

Comme rappelé ci-dessus, l'antenne monoconique est constituée d'une pièce métallique creuse en forme de cône de révolution C dont la pointe (apex) est au contact d'une source ponctuelle Sp qui est entourée, au plus près, d'un élément conducteur plan P perpendiculaire à l'axe du cône C.

De façon connue en soi, une onde électromagnétique qui se propage à partir de la source ponctuelle Sp est alors guidée entre la surface extérieure de la pièce métallique en forme de cône C et l'élément métallique plan P.

L'amplitude E du champ électrique présent en un point M situé à une distance r de la source, sur un axe faisant un angle θ par rapport à l'axe du cône, est donnée par l'équation :

$$E = \frac{V_e}{r \, \sin\theta \, Ln(cotg\left[\frac{\theta_o}{2}\right])}$$

où :

$V_e$ est l'amplitude de la tension incidente appliquée en entrée de l'antenne monocône et $\theta_o$ l'angle d'ouverture du cône.

Le gain en tension $|S_{21}|$ de l'antenne s'écrit :

$$|S_{21}| = \frac{V_S}{V_e}$$

où $V_S$ est l'amplitude de la tension de sortie du capteur et $V_e$ l'amplitude de la tension incidente appliquée en entrée de l'antenne monocône, comme mentionné ci-dessus.

Il est donc possible d'écrire :

$$E = \frac{V_S}{r \, \sin\theta \, Ln\left(cotg\left[\frac{\theta_o}{2}\right]\right)|S_{21}|}$$

L'ouverture $\theta_o$ de la pièce cônique est préférentiellment égale à 47°. L'amplitude $E_D$ du champ électrique mesuré par le capteur en surface de l'élément plan P, à une distance D de l'axe du cône s'écrit en conséquence:

$$E_D = \frac{V_s}{0.8328 \, |S_{21}| \, D}$$

De façon connue en soi, le gain G du capteur s'écrit, en fonction de la longueur d'onde λ de l'onde électromagnétique et de l'aire effective $A_{eff}$ :

$$G = \frac{4\pi \, A_{eff}}{\lambda^2}$$

Il est également connu que :

$$\frac{|E|^2}{377} = \frac{|V_S|^2}{50} \frac{4\pi}{G \lambda^2}$$

Il vient en conséquence :

$$G = \frac{377 \; 4\pi \; D \; 0.8328 \; f \; |S_{21}|^2}{450 \; 10^{16}}$$

où f est la fréquence de l'onde électromagnétique rayonnée par l'antenne monocônique. Il est alors possible d'afficher la courbe du gain G en fonction de la fréquence f de l'onde électromagnétique.

Le dispositif de l'invention permet avantageusement de faire des mesures de gain sur des bandes de fréquences très larges, par exemple la bande 100MHz - 40 GHz.

A l'aide du plateau tournant PT, il est également avantageusement possible de mesurer le gain en fonction de l'incidence de l'onde sur le capteur.

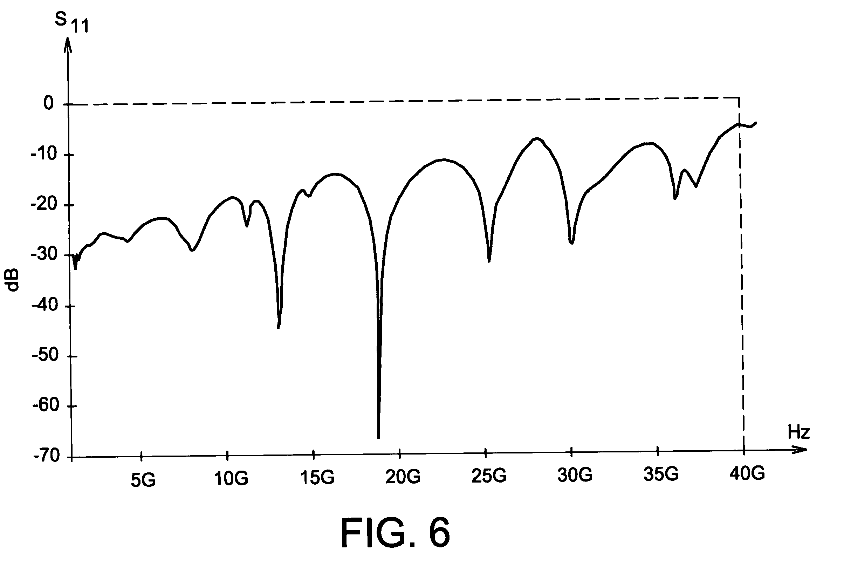

La figure 6 représente un exemple de mesure du coefficient de réflexion du dispositif de mesure de gain d'un capteur de champ électromagnétique conforme à l'invention, sur la bande de fréquences 200MHz-40GHz. Il apparait que le coefficient de réflexion $S_{11}$ (exprimé en décibels) varie de sensiblement -30dB à -15dB dans la bande 200MHz-20GHz et de -15dB à -5dB dans la bande 20GHz-40GHz. Un tel résultat de mesure confirme les excellentes performances du dispositif de mesure de gain de l'invention sur de très larges bandes de fréquences, comparativement aux dispositifs de mesure de gain de l'art antérieur.

## Revendications

1. Dispositif de mesure de gain de capteur (CP) de champ électromagnétique comprenant une source d'ondes électromagnétiques et une antenne reliée à la source d'ondes électromagnétiques et qui rayonne un champ électromagnétique en direction du capteur, l'antenne étant une antenne monocônique qui comprend un élément conducteur plan (P) ayant une première face et une deuxième face opposée à la première face et une pièce conductrice en forme de cône (C) située du côté de la première face, **caractérisé en ce que** :

   - l'élément conducteur plan (P) est constitué d'une plaque (1) munie d'une ouverture (2) dans laquelle est fixé un clinquant métallique flexible (3) muni d'une ouverture (4), le clinquant métallique flexible (3) ayant une première face et une deuxième face, la première face et la deuxième face du clinquant métallique flexible (3) étant respectivement situées du côté de la première face et du côté de la deuxième face de l'élément conducteur plan (P), la pièce conductrice en forme de cône comprenant un corps de cône (Q) et une pointe de cône (APX) fixé au corps de cône (Q), une extrémité de la pointe de cône étant positionnée en regard de l'ouverture du clinquant métallique, la première face de l'élément conducteur plan et une face extérieure de la pièce conductrice en forme de cône définissant, avec une paroi recouverte d'absorbant qui participe au dispositif de mesure et qui entoure la pièce en forme de cône, une chambre anéchoïde dans laquelle le capteur est placé,
   - une pièce de connexion électrique (9) traverse l'ouverture (4) du clinquant métallique flexible (3) et a une première extrémité fixée dans l'extrémité de la pointe de cône et une deuxième extrémité fixée à une première extrémité d'un câble coaxial (CX) fixé sur la deuxième face du clinquant métallique flexible par des moyens mécaniques (M), la deuxième extrémité du câble coaxial (CX) étant reliée à la source d'ondes électromagnétiques,
   - un système de suspension par câble (k1, k2, .., kN) maintient la pièce conductrice en forme de cône au-dessus de l'élément conducteur plan (P),
   - un système de mesure de tension (MT) relié au capteur est apte à mesurer une tension délivrée par le capteur, et
   - un dispositif de calcul (CA) relié au système de mesure de tension (MT) est apte à calculer un gain (G) du capteur à partir des mesures de tension délivrées par le système de mesure de tension.

2. Dispositif selon la revendication 1, dans lequel les moyens mécaniques (M) comprennent un connecteur (8) électriquement relié à la première extrémité du câble coaxial, le connecteur (8) ayant un conducteur central fixé à la deuxième extrémité de la pièce de connexion électrique (9).

3. Dispositif selon la revendication 1 ou 2, dans lequel le clinquant métallique flexible (3) est fixé à l'élément conducteur plan (P) par un ruban adhésif métallique (5).

4. Dispositif selon l'une quelconque des revendications 1 à 3, dans lequel l'élément conducteur plan (P) est muni d'un plateau tournant (PT) sur lequel est placé le capteur.

5. Dispositif selon l'une quelconque des revendications précédentes, dans lequel la pièce conductrice en forme de cône (C) est constituée de deux parties séparables vissées l'une avec l'autre, une première partie comprenant la pointe du cône et la deuxième partie constituant le corps du cône.

**Patentansprüche**

1. Vorrichtung zur Messung der Verstärkung eines Elektromagnetfeldsensors (CP), enthaltend eine elektromagnetische Strahlungsquelle und eine mit der elektronmagnetischen Strahlungsquelle verbundene Antenne, die ein elektromagnetisches Feld in Richtung des Sensors strahlt, wobei die Antenne eine monokonische Antenne ist, die ein flaches Leiterelement (P) mit einer ersten Fläche und einer der ersten Fläche entgegengesetzten zweiten Fläche und ein kegelförmiges Leiterstück (C) enthält, das sich auf der Seite der ersten Fläche befindet, **dadurch gekennzeichnet, dass**

    - das flache Leiterelement (P) aus einer Platte (1) besteht, die mit einer Öffnung (2) versehen ist, in welcher eine biegsame Metallfolie (3) befestigt ist, die mit einer Öffnung (4) versehen ist, wobei die biegsame Metallfolie (3) eine erste Fläche und eine zweite Fläche hat, wobei die erste Fläche und die zweite Fläche der biegsamen Metallfolie (3) auf der Seite der ersten Fläche bzw. auf der Seite der zweiten Fläche des flachen Leiterelements (P) liegen, wobei das kegelförmige Leiterstück einen Kegelkörper (Q) und eine Kegelspitze (APX) aufweist, die an den Kegelkörper (Q) befestigt ist, wobei ein Ende der Kegelspitze der Öffnung der Metallfolie gegenüberliegend positioniert ist, wobei die erste Fläche des flachen Leiterelements und eine Außenfläche des kegelförmigen Leiterstücks mit einer mit einem Absorptionsmittel bedeckten Wand, die zur Messvorrichtung gehört und das kegelförmige Stück umgibt, einen reflexionsarmen Raum definiert, in welchem der Sensor angeordnet ist,
    - ein elektrisches Verbindungsstück (9) sich durch die Öffnung (4) der biegsamen Metallfolie (3) erstreckt und mit einem ersten Ende an dem Ende der Kegelspitze befestigt ist und mit einem zweiten Ende an einem ersten Ende eines Koaxialkabels (CX) befestigt ist, das an der zweiten Fläche des biegsamen Metallfolie über mechanische Einrichtungen (M) befestigt ist, wobei das zweite Ende des Koaxialkabels (CX) mit der elektromagnetischen Strahlungsquelle verbunden ist,
    - eine Seilabhängungseinrichtung (k1, k2, ..., kN) das kegelförmige Leiterstück über dem flachen Leiterelement (P) hält,
    - eine Spannungsmesseinrichtung (MT), die mit dem Sensor verbunden ist, dazu geeignet ist, eine von dem Sensor abgegebene Spannung zu messen, und
    - eine mit der Spannungsmesseinrichtung (MT) verbundene Recheneinrichtung (CA) dazu geeignet ist, eine Verstärkung (G) des Sensors ausgehend von den von der Spannungsmesseinrichtung gelieferten Spannungsmessungen zu berechnen.

2. Vorrichtung nach Anspruch 1, wobei die mechanischen Einrichtungen (M) einen Verbinder (8) aufweisen, der elektrisch mit dem ersten Ende des Koaxialkabels verbunden ist, wobei der Verbinder (8) einen mittleren Leiter hat, der an das zweite Ende des elektrischen Verbindungsstücks (9) befestigt ist.

3. Vorrichtung nach Anspruch 1 oder 2, wobei die biegsame Metallfolie (3) an das flache Leiterelement (P) über ein metallisches Klebeband (5) befestigt ist.

4. Vorrichtung nach einem der Ansprüche 1 bis 3, wobei das flache Leiterelement (P) mit einer drehbaren Platte (PT) versehen ist, auf welcher der Sensor angeordnet ist.

5. Vorrichtung nach einem der vorangehenden Ansprüche, wobei das kegelförmige Leiterstück (C) aus zwei lösbar miteinander verschraubten Teilen besteht, wobei ein erster Teil die Kegelspitze aufweist und der zweite Teil den Kegelkörper bildet.

**Claims**

1. Device for measuring electromagnetic field sensor (CP) gain comprising an electromagnetic wave source and an antenna connected to the electromagnetic wave source and radiating an electromagnetic field in the direction of the sensor, the antenna is a monocone antenna comprising a plane conductive element (P) having a first face and a second face opposite the first face and a cone-shaped conductive part (C) situated on the side of the first face, **characterised in that**:

    - the plane conductive element (P) consisting of a plate (1) furnished with an opening (2) wherein a flexible metal foil (3) furnished with an opening (4) is attached, the flexible foil (3) having a first face and a second face, the first face and the second face of the flexible metal foil (3) being respectively situated on the side of the first face and on the side of the second face of the plane conductive element (P), the cone-shaped conductive part comprising a cone body (Q) and a cone apex (APX) attached to the cone body (Q), one end of the cone apex being positioned facing the opening of the metal foil, the first face of the plane conductive element and an external face of the cone-shaped conductive part defining, with a wall covered with absorbent included in the measurement device and surrounding the cone-shaped part, an anechoic chamber wherein the sensor is positioned,

- an electrical connection part (9) traverses the opening (4) of the flexible metal foil (3) and has a first end attached in the end of the cone apex and a second end attached to a first end of a coaxial cable (CX) attached to the second face of the flexible metal foil by mechanical means (M), the second end of the coaxial cable (CX) being connected to the electromagnetic wave source,

- a cable suspension system (k1, k2, ..., kN) holds the cone-shaped conductive part above the plane conductive element (P),

- a system for measuring voltage (MT) connected to the sensor is suitable for measuring a voltage output by the sensor, and

- a computing device (CA) connected to the voltage measurement system (MT) is suitable for computing a sensor gain (G) on the basis of the voltage measurements output by the voltage measurement system.

2. Device according to claim 1, wherein the mechanical means (M) comprise a connector (8) electrically connected to the end of the coaxial cable, the connector (8) having a central wire attached to the second end of the electrical connection part (9).

3. Device according to claim 1 or 2, wherein the flexible metal foil (3) is attached to the plane conductive element (P) by a metallic adhesive tape (5).

4. Device according to any of claims 1 to 3, wherein the plane conductive element (P) is furnished with a revolving plate (PT) whereon the sensor is positioned.

5. Device according to any of the above claims, wherein the cone-shaped conductive part (C) consists of two separable parts screwed onto each other, a first part comprising the apex of the cone and the second part forming the body of the cone.

FIG. 1

# FIG. 2

FIG. 3

FIG. 4A

FIG. 4B

FIG. 4C

FIG. 4D

FIG. 4E

FIG. 5

EP 2 895 871 B1

## FIG. 6

EP 2 895 871 B1